# EUROPEAN PATENT APPLICATION

(11) **EP 3 700 315 A1**
(43) Date of publication of application: **26.08.2020**
(21) Application number: 20158417.4
(22) Date of filing: 20.02.2020
(51) Int. Cl.: H05K 7/20

(54) **POWER CONVERTER**

(30) Priority: 20.02.2019 JP 2019028751
(71) Applicant: Kabushiki Kaisha Yaskawa Denki, Kitakyushu-shi, Fukuoka 806-0004 (JP)
(72) Inventor: SAKAI, Masafumi, Kitakyushu-shi, Fukuoka 806-0004 (JP); ONO, Mitsutaka, Kitakyushu-shi, Fukuoka 806-0004 (JP); TOYAMA, Tetsuya, Kitakyushu-shi, Fukuoka 806-0004 (JP)
(74) Representative: Viering, Jentschura & Partner mbB Patent- und Rechtsanwälte

(57) **Abstract**

A power converter includes a heat sink, a plurality of switching devices, and an electro-conductive member. The heat sink has a mount surface. The plurality of switching devices are disposed on the mount surface. Each switching device of the plurality of switching devices has a terminal. The electro-conductive member has a planar shape. The electro-conductive member is connected to the terminal of the each switching device and faces the mount surface with the plurality of switching devices disposed between the electro-conductive member and the mount surface.

## Description

### BACKGROUND

### FIELD OF THE INVENTION

The present invention relates to a power converter.

### DISCUSSION OF THE BACKGROUND

Patent document 1 discloses a power converter that includes a switching device, a capacitor, a cooler, a first connector, a second connector, and a heat-conductive member. The switching device opens and closes a current path using an electrical signal. The capacitor smoothens power input into the switching device. The cooler cools the switching device and the capacitor. The first connector is connected to the switching device. The second connector is connected to the first connector and the capacitor. The heat-conductive member conducts heat from the first connector and the second connector to the cooler.

### Related Art Documents

### Patent Documents

Patent document 1: JP 2018-67998A

The above-described power converter may not necessarily provide a sufficient level of coolability, leaving a need for a higher level of coolability.

The present invention has been made in view of the above circumstances, and it is an object of the present invention to provide a power converter that has an increased level of coolability.

### SUMMARY

According to one aspect of the present disclosure, a power converter includes a heat sink, a plurality of switching devices, and an electro-conductive member. The heat sink has a mount surface. The plurality of switching devices are disposed on the mount surface. Each switching device of the plurality of switching devices has a terminal. The electro-conductive member has a planar shape. The electro-conductive member is connected to the terminal of the each switching device and faces the mount surface with the plurality of switching devices disposed between the electro-conductive member and the mount surface.

The above-described aspect of the present invention provides an increased level of coolability.

### BRIEF DESCRIPTION OF THE DRAWINGS

A more complete appreciation of the present invention and many of the attendant advantages thereof will be readily obtained as the same becomes better understood by reference to the following detailed description when considered in connection with the accompanying drawings, wherein:
FIG. 1 is a circuit diagram illustrating an example circuit configuration of a power converter according to an embodiment;
FIG. 2 is a perspective view of a main part extracted out from the internal structure of the power converter;
FIG. 3 is a side view of a main part extracted out from the internal structure of the power converter;
FIG. 4 is a front view of a structure around the heat-conductive member disposed between adjacent switching devices; and
FIG. 5 is a perspective view of the heat-conductive member illustrating its entire structure;

### DESCRIPTION OF THE EMBODIMENTS

The embodiments will now be described with reference to the accompanying drawings, wherein like reference numerals designate corresponding or identical elements throughout the various drawings.

### 1. Circuit Configuration of Power Converter

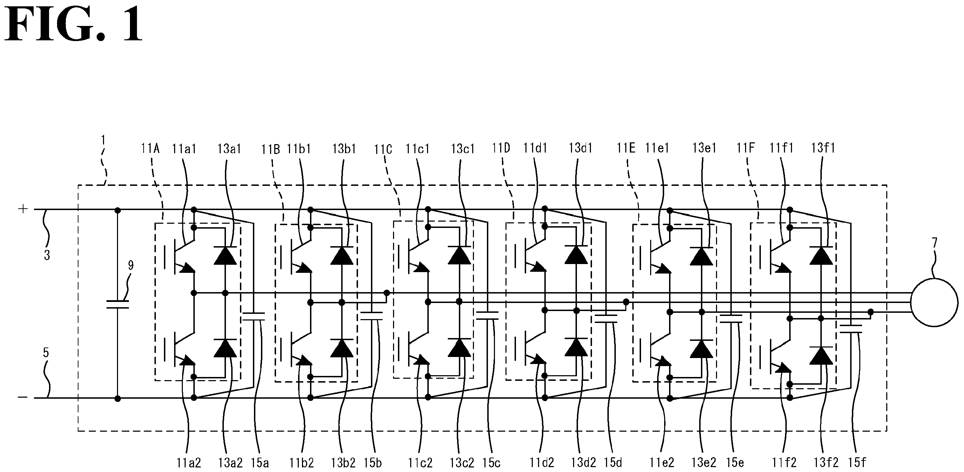

By referring to FIG. 1, an example circuit configuration of a power converter 1 according to this embodiment will be described. FIG. 1 is a circuit diagram illustrating an example circuit configuration of the power converter 1 according to this embodiment.

As illustrated in FIG. 1, the power converter 1 receives DC (direct-current) power from DC bus lines 3 and 5; converts the DC power into AC (alternating-current) power; and outputs the AC power to a load 7. A non-limiting example of the load 7 is a generator. The power converter 1 includes smoothing capacitors 9, switching devices 11A, 11B, 11C, 11D, 11E, and 11F, and snubber capacitors 15a, 15b, 15c, 15d, 15e, and 15f. It is to be noted that the power converter 1 may be used in large-capacity applications such as in wind power generation or may be used in small-to-middle capacity applications such as in solar photovoltaic generation.

The smoothing capacitors 9 are disposed between and connected to the DC bus lines 3 and 5, and smoothens DC power input from the DC bus lines 3 and 5. Examples of each smoothing capacitor 9 include, but are not limited to, an aluminum electrolytic capacitor, an electric double layer capacitor, and a film capacitor.

The switching devices 11A, 11B, 11C, 11D, 11E, and 11F are connected in parallel to the smoothing capacitors 9. The switching device 11A includes two switching devices 11a1 and 11a2 and two diodes 13a1 and 13a2. The switching devices 11a1 and 11a2 are connected in series to each other between the DC bus lines 3 and 5, and open and close a current path in response to an electrical signal (gate signal) from a controller, not illustrated. The diodes 13a1 and 13a2 are arranged in parallel to the respective switching devices 11a1 and 11a2, and rectify current by making current flow in one direction. The other switching devices 11B, 11C, 11D, 11E, and 11F each have a configuration similar to the above-described configuration of the switching device 11A. The switching devices 11A and 11B, the switching devices 11C and 11D, and the switching devices 11E and 11F form three pairs to convert DC power into three-phase AC power and output the three-phase AC power to the load 7.

In the example illustrated in FIG. 1, the output of a pair of switching devices 11 is input into one phase of the load 7. When, however, the power converter 1 has a smaller capacity, the output of one switching device 11 may be input into one phase of the load 7.

Examples of the switching device 11 include, but are not limited to, an insulated gate bipolar transistor (IGBT) and a field-effect transistor (FET, including a metal-oxide-semiconductor field-effect transistor (MOSFET) and a super-junction metal-oxide-semiconductor field-effect transistor (SJ-MOSFET)). When the switching device 11 is a MOSFET, such a configuration is possible that a parasitic diode is used as the diode 13, that is, no diode 13 is provided outside the switching device 11.

The snubber capacitors 15a, 15b, 15c, 15d, 15e, and 15f are connected in parallel to the respective switching devices 11A, 11B, 11C, 11D, 11E, and 11F. Each snubber capacitor 15 (which is a non-limiting example of the surge absorbing member recited in the claims) absorbs surge current generated in the opening and closing of the corresponding switching device 11, thereby eliminating or minimizing a surge occurrence. It is to be noted that a snubber resistor may be connected in series to each snubber capacitor 15.

### 2. Hardware Configuration of Power Converter

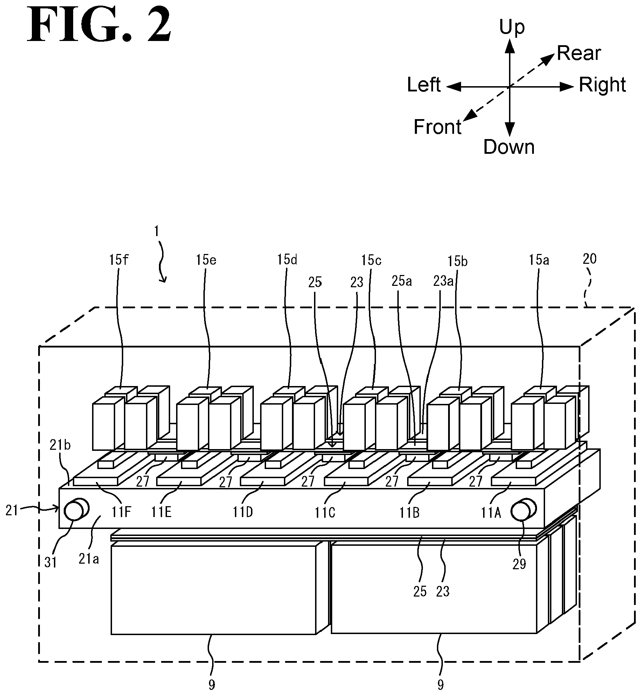

By referring to FIGs. 2 to 5, an example hardware configuration of the power converter 1 will be described. The following description uses "up", "down", "right", "left", "front", "rear", and other direction indicating terms for convenience of description of a configuration of the power converter 1 and other configurations. These direction indicating terms, however, are not intended as limiting the relative positions of these configurations.

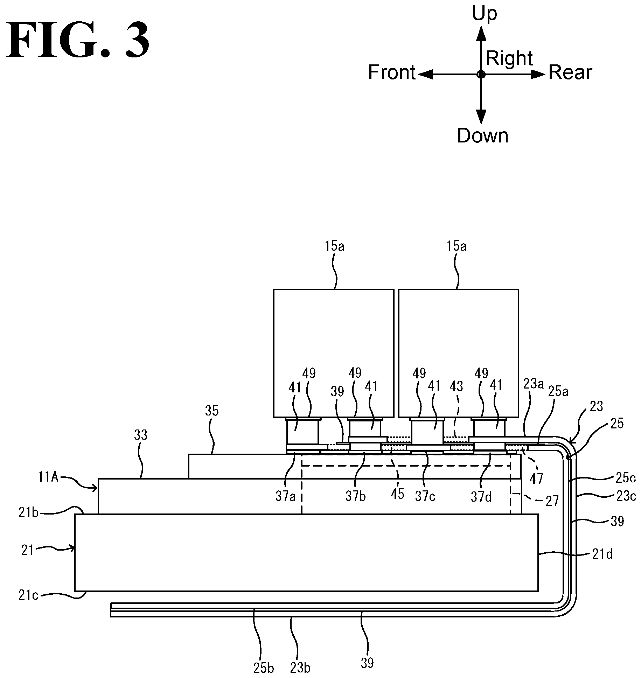

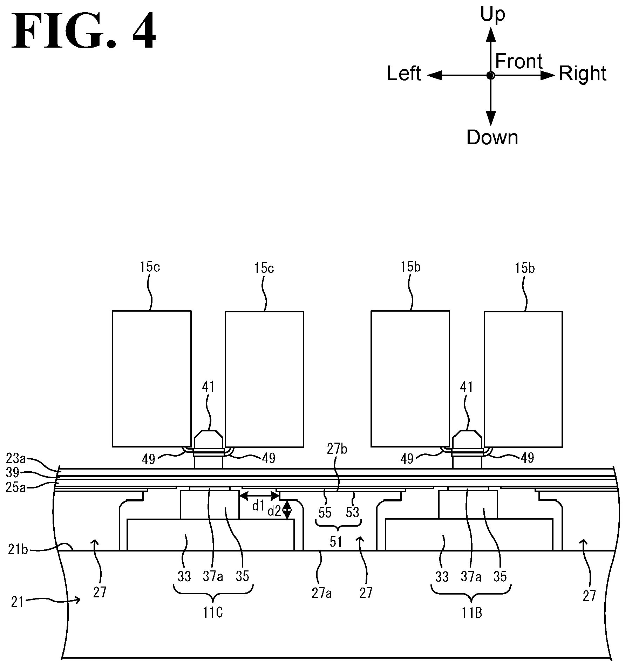

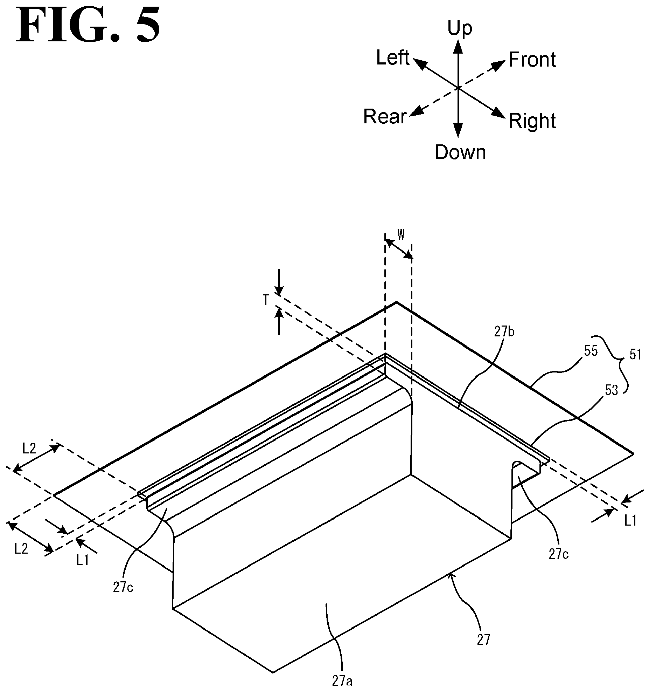

FIG. 2 is a perspective view of a main part extracted out from the internal structure of the power converter 1. It is to be noted that FIG. 2 omits illustration of: DC power input terminals and bus bars connected to these DC power input terminals; and AC power output terminals and bus bars connected to these AC power output terminals. FIG. 3 is a side view of a main part extracted out from the internal structure of the power converter 1. FIG. 4 is a front view of a structure around the heat-conductive member disposed between adjacent switching devices. FIG. 5 is a perspective view of the heat-conductive member illustrating its entire structure.

As illustrated in FIG. 2, the power converter 1 includes a housing 20, a heat sink 21, the six switching devices 11A, 11B, 11C, 11D, 11E, and 11F, bus bars 23 and 25, the smoothing capacitors 9, the snubber capacitors 15a, 15b, 15c, 15d, 15e, and 15f, and a heat-conductive member 27.

The heat sink 21 is a liquid-cooled heat sink, in which a liquid refrigerant flows. In the example illustrated in FIG. 2, the heat sink 21 includes: a refrigerant inlet 29 at a left side portion on the front surface, 21a, of the heat sink 21; and a refrigerant outlet 31 at a right side portion on the front surface 21a. In the heat sink 21, a refrigerant path, not illustrated, is disposed. The refrigerant path has two ends connected to the refrigerant inlet 29 and the refrigerant outlet 31, and meanders between the refrigerant inlet 29 and the refrigerant outlet 31.

On the upper surface, 21b, of the heat sink 21 (hereinafter occasionally referred to as "mount surface 21b"), the switching devices 11A, 11B, 11C, 11D, 11E, and 11F are disposed approximately at equal spatial intervals in the right-left directions. As illustrated in FIGs. 3 and 4, each switching device 11 includes a body 33 and a protrusion 35. The body 33 is in contact with the mount surface 21b of the heat sink 21. The protrusion 35 protrudes upward at a rear portion of the body 33. Each switching device 11 also includes, on the protrusion 35, a plurality of terminals 37a, 37b, 37c, and 37d (four terminals in this embodiment).

The bus bars 23 and 25 are electro-conductive members each having a planar shape. The bus bar 23 is an electro-conductive member usable for a positive electrode, and the bus bar 25 is an electro-conductive member usable for a negative electrode. As illustrated in FIG. 3, the bus bar 23 includes a first bus bar 23a, a second bus bar 23b, and a third bus bar 23c. The first bus bar 23a (which is a non-limiting example of the electro-conductive member and the first electro-conductive member recited in the claims) is disposed above the heat sink 21, is parallel to the mount surface 21b, and faces the mount surface 21b. The second bus bar 23b is disposed below the heat sink 21, is parallel to the lower surface, 21c, of the heat sink 21, and faces the lower surface 21c. The third bus bar 23c is disposed behind the heat sink 21, is parallel to the rear surface, 21d, of the heat sink 21, and faces the rear surface 21d. The first bus bar 23a, the second bus bar 23b, and the third bus bar 23c are integrally connected to each other, and are formed by, for example, folding a planar electro-conductive member at two positions approximately perpendicularly.

Similarly, the bus bar 25 includes a first bus bar 25a, a second bus bar 25b, and a third bus bar 25c. The first bus bar 25a (which is a non-limiting example of the conduction member and the second conduction member recited in the claims) is disposed above the heat sink 21, is parallel to the mount surface 21b, and faces the mount surface 21b. The second bus bar 25b is disposed below the heat sink 21, is parallel to the lower surface 21c, and faces the lower surface 21c. The third bus bar 25c is disposed behind the heat sink 21, is parallel to the rear surface 21d, and faces the rear surface 21d. The first bus bar 25a, the second bus bar 25b, and the third bus bar 25c are integrally connected to each other, and are formed by, for example, folding a planar electro-conductive member at two positions approximately perpendicularly.

The bus bar 23 and the bus bar 25 thus configured are laminated on each other via an electro-insulating sheet 39 (which is a non-limiting example of the second electro-insulating member recited in the claims). That is, the first bus bar 23a and the first bus bar 25a are laminated on each other via the electro-insulating sheet 39 in a direction (up or down direction) perpendicular to the mount surface 21b. Similarly, the second bus bar 23b and the second bus bar 25b are laminated on each other via the electro-insulating sheet 39 in a direction (up or down direction) perpendicular to the lower surface 21c. Similarly, the third bus bar 23c and the third bus bar 25c are laminated on each other via the electro-insulating sheet 39 in a direction (front-rear direction) perpendicular to the rear surface 21d.

As illustrated in FIG. 2, the first bus bar 23a of the bus bar 23 extends in the right-left directions between the protrusion 35 of the switching device 11A, which is the right end switching device 11, and the protrusion 35 of the switching device 11F, which is the left end switching device 11. As illustrated in FIG. 3, the first bus bar 23a extends in the front-rear directions between the third bus bar 23c and a terminal 37b of the switching device 11A. The first bus bar 23a is electrically connected to the terminal 37b and a terminal 37d of the switching device 11A via cylindrical collar members 41, which is disposed above the terminals 37b and 37d. An opening 43 is formed at a position corresponding to a terminal 37c on the first bus bar 23a (the opening 43 is indicated in dotted lines for distinguishing purposes in relation to solid lines indicating non-opening portions) so that the first bus bar 23a is kept out of connection with the terminal 37c. It is to be noted that the opening 43 defines a gap large enough to ensure an insulation state with the collar members 41, which are disposed above the terminal 37c. It is also to be noted that the first bus bar 23a only extends as far as a position corresponding to the terminal 37b, as described above, and thus is kept out of connection with a terminal 37a.

Similarly, the first bus bar 25a of the bus bar 25 extends in the right-left directions between the protrusion 35 of the switching device 11A, which is the right end switching device 11, and the protrusion 35 of the switching device 11F, which is the left end switching device 11. As illustrated in FIG. 3, the first bus bar 25a extends in the front-rear directions between the third bus bar 25c and the terminal 37a of the switching device 11A. The first bus bar 25a is electrically connected to the terminal 37a and the terminal 37c of the switching device 11A directly or via the cylindrical collar members 41, which are disposed above the terminals 37a and 37c. Openings 45 and 47 are formed at positions corresponding to the terminals 37b and 37d on the first bus bar 25a (the openings 45 and 47 are indicated in dotted lines for distinguishing purposes in relation to solid lines indicating non-opening portions) so that the first bus bar 25a is kept out of connection with the terminals 37b and 37d. It is to be noted that the openings 45 and 47 have gaps large enough to ensure insulation states with the collar members 41, which are disposed above the terminals 37b and 37d.

With the above-described configurations, the first bus bar 23a of the bus bar 23 and the first bus bar 25a of the bus bar 25 face the mount surface 21b of the heat sink 21 with the plurality of switching devices 11A, 11B, 11C, 11D, 11E, and 11F disposed between the mount surface 21b and the first bus bars.

In this embodiment, the bus bars 23 and 25 have planar shapes even at their connection portions with the terminals 37a to 37d of the switching devices 11. The connection portions, however, may be other than planar shapes such as depression-protrusion shapes. More specifically, the terms and phrases "planar electro-conductive member" and "electro-conductive member having a planar shape", as used herein, are intended to encompass such an electro-conductive member that is planar at portions other than those in contact with the terminals 37a to 37d and that is not planar at portions around the portions in contact with the terminals 37a to 37d. Also, the term "electro-conductive member", as used herein, is intended to mean that not all of the electro-conductive member need to face the mount surface 21b; that is, it suffices that at least part of the electro-conductive member faces the mount surface 21b, as do the first bus bars 23a and 25a of the bus bars 23 and 25 according to this embodiment.

As illustrated in FIG. 2, six smoothing capacitors 9 are disposed under the heat sink 21. At an upper end portion of each smoothing capacitor 9, a terminal (not illustrated) is provided and electrically connected to the second bus bar 23b of the bus bar 23 and the second bus bar 25b of the bus bar 25. It is to be noted that there may be other than six smoothing capacitors 9 or may be a single smoothing capacitor 9.

As illustrated in FIG. 2, the snubber capacitors 15a, 15b, 15c, 15d, 15e, and 15f are disposed at positions opposite to the switching devices 11A, 11B, 11C, 11D, 11E, and 11F across the first bus bar 23a of the bus bar 23 and the first bus bar 25a of the bus bar 25. In the example illustrated in FIG. 2, four snubber capacitors 15 are provided for one switching device 11. It is to be noted, however, that other than four snubber capacitors 15 or a single snubber capacitor 15 may be provided for one switching device 11. Referring to the switching device 11A illustrated in FIG. 1, the snubber capacitors 15 may be connected in parallel to the series assembly of the switching devices 11a1 and 11a2, or the snubber capacitors 15 may be classified into two groups, one group being connected in parallel to the switching device 11a1 and the other group being connected in parallel to the switching device 11a2. As illustrated in FIGs. 3 and 4, each snubber capacitor 15 is connected to the collar members 41 via two terminals 49. This ensures that the two front snubber capacitors 15 are electrically connected to the terminals 37a and 37b of each switching device 11, and the two rear snubber capacitors 15 are electrically connected to the terminals 37c and 37d of each switching device 11. It is to be noted that each snubber capacitor 15 may be supported by the collar members 41 and the terminals 49 or may be supported by an additionally provided support member (not illustrated).

As illustrated in FIGs. 2 and 4, the heat-conductive member 27 is disposed between adjacent switching devices 11. The heat-conductive member 27 is made of a material having a high level of heat conductivity (such as an aluminum alloy), and conducts heat from the bus bars 23 and 25 to the heat sink 21. As illustrated in FIG. 3, the heat-conductive member 27 is disposed near the terminals 37a, 37b, 37c, and 37d of each switching device 11 in the front-rear directions. As used herein, the phrase "disposed near" is intended to mean that when viewed from a direction perpendicular to an arrangement direction of the terminals (37a, 37b, 37c, 37d) of each switching device 11, all or much of the heat-conductive member 27 in the front-rear directions is disposed within the range defined between the terminal 37a and the terminal 37d. In other words, as viewed from the right or left direction, all or much of the heat-conductive member 27 in the front-rear directions is disposed within the range defined between the terminal 37a and the terminal 37d of each switching device 11.
As illustrated in FIGs. 4 and 5, the heat-conductive member 27 includes a first end surface 27a and a second end surface 27b. The first end surface 27a faces the mount surface 21b of the heat sink 21, and the second end surface 27b faces the bus bars 23 and 25. In the example illustrated in FIGs. 4 and 5, the heat-conductive member 27 has an approximate T shape as viewed from the front or rear direction; accordingly, the area of the second end surface 27b is larger than the area of the first end surface 27a. It is to be noted that the heat-conductive member 27 may have other than a T shape, examples including a trapezoid shape and a trumpet shape.

The first end surface 27a of the heat-conductive member 27 is fixed to and closely contacts the mount surface 21b via a material having a high level of heat conductivity (such as a heat-discharging compound, a heat-discharging grease, and a heat-discharging sheet). The second end surface 27b of the heat-conductive member 27 is fixed to and closely contacts the first bus bar 25a of the bus bar 25 via an electro-insulating member 51. The electro-insulating member 51 (which is a non-limiting example of the first electro-insulating member recited in the claims) has a heat conductivity. The electro-insulating member 51 may be made up of a single component. In this embodiment, however, the electro-insulating member 51 is made up of a plurality of components, namely, a heat-discharging sheet 53 and an electro-insulating sheet 55.

The heat-discharging sheet 53 not only has a high level of heat conductivity but also has a flexibility, and has a thickness larger than the thickness of the electro-insulating sheet 55. With this configuration, the heat-discharging sheet 53 serves as a cushion between the heat-conductive member 27 and the electro-insulating sheet 55 to protect the electro-insulating sheet 55 from damage occurrable due to contact with the heat-conductive member 27, especially on its corners. As illustrated in FIGs. 4 and 5, the heat-discharging sheet 53 has larger size than the second end surface 27b by a predetermined dimension *L1* in plane directions of the second end surface 27b of the heat-conductive member 27 (that is, the heat-discharging sheet 53 has larger size than the second end surface 27b by the predetermined dimension *L1* both in the right-left directions and the front-rear directions). The predetermined dimension *L1* is set at a level that ensures the above-described function of preventing damage to the electro-insulating sheet 55.

The electro-insulating sheet 55 has a high level of electro-insulating property, and has larger size than the second end surface 27b by a predetermined dimension *L2* in the plane directions of the second end surface 27b (both in the right-left and the front-rear directions of the second end surface 27b). The predetermined dimension *L2* is set at a level that ensures a necessary level of creepage distance between the surface of the bus bar 25 and the surface of the heat-conductive member 27.

The heat-conductive member 27 includes protrusions 27c, which protrude from the body of the heat-conductive member 27 in the right-left directions. Each protrusion 27c has a width *W* in the right-left directions and a thickness *T* in the up-down directions. From a viewpoint of heat conduction efficiency, the width *W* and the thickness *T* are preferably as high as possible. In this embodiment, the width *W* and the thickness T of each protrusion 27c are set at maximum levels while ensuring that a necessary electro-insulation distance *d1* is defined between the protrusion 27c and the protrusion 35 (the terminal 37) of the switching device 11 and that a necessary electro-insulation distance *d2* is defined between the protrusion 27c and the body, 33, of the switching device 11.

### 3. Advantageous Effects of the Embodiment

As has been described hereinbefore, the power converter 1 according to this embodiment includes the heat sink 21, the plurality of switching devices 11A to 11F, and the planar bus bars 23 and 25. The heat sink 21 has the mount surface 21b. The plurality of switching devices 11A to 11F are disposed on the mount surface 21b, and each of the plurality of switching devices 11A to 11F has the terminals 37a to 37d. The bus bars 23 and 25 are connected to the terminals 37a to 37d of the plurality of switching devices 11A to 11F, and face the mount surface 21b with the plurality of switching devices 11A to 11F disposed between the bus bars 23 and 25 and the mount surface 21b. This configuration provides the following advantageous effects.

When heat occurs in the switching device 11, the heat is generally conducted through three paths, namely, a first path, a second path, and a third path. The first path conducts heat from the mount surface 21b to the heat sink 21. The second path conducts heat from the terminals 37a to 37d to the bus bars 23 and 25, which are connected to the terminals 37a to 37d. The third path conducts heat to surrounding air with radiation.

In this embodiment, the planar bus bars 23 and 25 are used, and the first bus bars 23a and 25a respectively of the bus bars 23 and 25 face the mount surface 21b with the plurality of switching devices 11A to 11F disposed between the first bus bars 23a and 25a and the mount surface 21b. This ensures that the space opposite to the heat sink 21 across the switching devices 11A to 11F can be utilized for the first bus bars 23a and 25a, making the first bus bars 23a and 25a larger in size in the plane directions. This increases the surface areas of the first bus bars 23a and 25a, increasing the amount of heat radiation from the first bus bars 23a and 25a. As a result, the cooling efficiency in the second path increases. In this manner, the power converter 1 provides an increased level of coolability. Additionally, the planar first bus bars 23a and 25a serve as walls against radiant heat from the switching devices 11A to 11F and/or heat conducted from the switching devices 11A to 11F through air. This eliminates or minimizes adverse effects that conducted heat has on the snubber capacitors 15 and/or other components disposed at positions opposite to the switching devices 11A to 11F across the first bus bars 23a and 25a (an example adverse effect is a shortened lifetime of the snubber capacitor 15).

Also in this embodiment, the power converter 1 further includes the heat-conductive member 27. The heat-conductive member 27 is disposed between adjacent switching devices 11 and conducts heat from the first bus bars 23a and 25a to the heat sink 21.

As described above, the first bus bars 23a and 25a are planar electro-conductive members that are large in size in the plane directions. Using this nature of the first bus bars 23a and 25a, the heat-conductive member 27 is disposed between adjacent switching devices 11 and closely contacts the heat sink 21 and the first bus bar 25a. This ensures that heat conducted from the terminals 37a to 37d of the switching devices 11 to the first bus bars 23a and 25a is actively conducted to the heat sink 21. This configuration further increases the cooling efficiency in the second path, resulting in a further increased level of coolability. The above configuration also ensures that the space between adjacent switching devices 11 is utilized effectively with no or minimal dead space.

Also in this embodiment, the heat-conductive member 27 is disposed near the terminals 37a to 37d of each switching device 11. The second path conducts heat generated by the switching device 11 from the terminals 37a to 37d to the first bus bars 23a and 25a. In light of this fact, the terminals 37a to 37d can be regarded as heat sources. In this embodiment, the heat-conductive member 27 is disposed near the heat sources. This further increases the cooling efficiency in the second path.

Also in this embodiment, the heat-conductive member 27 has the first end surface 27a and the second end surface 27b. The first end surface 27a faces the mount surface 21b, and the second end surface 27b faces the first bus bars 23a and 25a and is larger in area than the first end surface 27a. This increases the contact area between the heat-conductive member 27 and the first bus bars 23a and 25a, increasing the efficiency of heat conduction from the first bus bars 23a and 25a to the heat-conductive member 27. As a result, the first bus bars 23a and 25a are cooled efficiently.

Also in this embodiment, the power converter 1 further includes the electro-insulating member 51. The electro-insulating member 51 is disposed between the second end surface 27b of the heat-conductive member 27 and the first bus bars 23a and 25a, and has a heat conductivity. The electro-insulating member 51 has larger size than the second end surface 27b by the predetermined dimension *L2* in the plane directions of the second end surface 27b. This configuration provides the following advantageous effects.

Generally, an aluminum alloy or a similar substance is used for the material of the heat-conductive member 27, from a viewpoint of heat conductivity combined with a viewpoint of cost effectiveness. This creates a need for establishing an electro-insulation between the heat-conductive member 27 and the first bus bars 23a and 25a and/or between the heat-conductive member 27 and the heat sink 21. In this embodiment, the electro-insulating member 51, which has a heat conductivity, is disposed between the heat-conductive member 27 and the first bus bars 23a and 25a. This ensures a high level of heat conductivity between the heat-conductive member 27 and the first bus bars 23a and 25a while ensuring an electro-insulation between the heat-conductive member 27 and the first bus bars 23a and 25a. Further, the electro-insulating member 51 has larger size than the second end surface 27b by the predetermined dimension *L2* in the plane directions of the second end surface 27b. This ensures a necessary level of creepage distance secured between the surface of the first bus bar 25a and the surface of the heat-conductive member 27, resulting in an increased level of insulating property.

Also in this embodiment, the bus bar 23 includes the first bus bar 23a, and the bus bar 25 includes the first bus bar 25a. The first bus bar 23a has a planar shape parallel to the mount surface 21b and is usable for a positive electrode. The first bus bar 25a has a planar shape parallel to the mount surface 21b and is usable for a negative electrode. The first bus bar 23a and the first bus bar 25a are laminated on each other in a direction perpendicular to the mount surface 21b via the electro-insulating sheet 39, which has a heat conductivity. This configuration ensures that not only the first bus bar 25a, which is the lower-side first bus bar contacting the heat-conductive member 27, but also the first bus bar 23a, which is the upper-side first bus bar, are efficiently cooled while ensuring an electro-insulation between the first bus bar 23a and the first bus bar 25a. The above configuration also ensures that even when the first bus bars 23a and 25a are made up of a plurality of different-potential components, the planar bus bar structure of each first bus bar facing the mount surface 21b of the heat sink 21 is maintained.

Also in this embodiment, the power converter 1 further includes the snubber capacitors 15. The snubber capacitors 15 are disposed at positions opposite to the first bus bars 23a and 25a across the switching devices 11A to 11F, and are connected to the terminals 37a to 37d of the switching devices 11A to 11F. This configuration provides the following advantageous effects.

The snubber capacitors 15 have lower heat resistivity than the switching devices 11; if external heat is conducted to the snubber capacitors 15, their lifetime may be shortened. In this embodiment, an increased amount of heat is radiated from the first bus bars 23a and 25a in the second path, as described above. This enables the terminals 37a to 37d of the switching devices 11 to be cooled to a sufficient level. As a result, heat conduction to the snubber capacitors 15, which are connected to the terminals 37a to 37d, is eliminated or minimized. Also, the planar first bus bars 23a and 25a serve as walls to protect the snubber capacitors 15 from radiant heat and/or heat conducted through air from the switching devices 11. This eliminates or minimizes an increase in the temperature of the snubber capacitors 15, preventing the snubber capacitors 15 from being shortened in lifetime.

Also in this embodiment, the heat sink 21 is a liquid-cooled heat sink in which a liquid refrigerant flows. This enables the heat sink 21 to provide superior coolability to air-cooled heat sinks, and eliminates the need for a cooling fin, resulting in a downsized device. Since the heat sink 21 provides superior coolability, the installment of the heat-conductive member 27 is particularly effective, making the cooling efficiency in the second path even higher.

### 4. Modifications

Modifications of the above-described embodiment will be described below.

In the above-described embodiment, the heat sink 21 is a liquid-cooled heat sink. Another possible example of the heat sink 21 is an air-cooled heat sink. In this case, a fin may be provided at a position opposite to the heat sink across the switching devices 11, and a fan may be provided in the housing 20 so that the fan causes forced convection to occur to implement cooling.

In the above-described embodiment, due consideration is not given to cooling of the snubber capacitors 15. It is possible, however, to cool the snubber capacitors 15 by making effective use of the gap defined between the snubber capacitors 15 and the first bus bars 23a and 25a due to the presence of the collar members 41. Specifically, it is possible to circulate cooling air through the gap in the right-left directions using, for example, a fan provided in the housing 20, thereby cooling the snubber capacitors 15.

In the above-described embodiment, the electro-insulating member 51 is disposed between the first bus bar 25a and the second end surface 27b of the heat-conductive member 27. Another possible example is that the electro-insulating member 51 is disposed between the first end surface 27a of the heat-conductive member 27 and the mount surface 21b of the heat sink 21. In this case, the electro-insulating member 51 may be larger in size than the first end surface 27a by a predetermined dimension in the plane directions of the first end surface 27a (the predetermined dimension is set at a level that ensures a necessary level of creepage distance between the surface of the heat-conductive member 27 and the mount surface 21b). Also, the electro-insulating member 51 may be disposed both between the first bus bar 25a and the second end surface 27b and between the first end surface 27a and the mount surface 21b.

In the above-described embodiment, the heat-conductive member 27 is made of an aluminum alloy. The heat-conductive member 27, however, may be made of a metal material other than aluminum or made of an electro-insulating material having a heat conductivity (such as resin). When the heat-conductive member 27 is made of an electro-insulating material having a heat conductivity, there is no need for providing the electro-insulating member 51.

As used herein, the term "perpendicular" means substantially or approximately perpendicular within some design tolerance or manufacturing tolerance, as well as precisely perpendicular. As used herein, the term "parallel" means substantially or approximately parallel within some design tolerance or manufacturing tolerance, as well as precisely parallel. As used herein, the term "planar" means substantially or approximately planar within some design tolerance or manufacturing tolerance, as well as precisely planar.

Also, when the terms "identical", "same", "equivalent", and "different" are used in the context of dimensions, magnitudes, sizes, or positions, these terms may not necessarily mean "identical", "same", "equivalent", and "different", respectively, in a strict sense. Specifically, the terms "identical", "same", "equivalent", and "different" are intended to mean "approximately identical", "approximately same", "approximately equivalent", and "approximately different", respectively, with design-related and production-related tolerance and error taken into consideration.

Otherwise, the above-described embodiments and modifications may be combined in any manner deemed suitable. Obviously, numerous modifications and variations of the present invention are possible in light of the above teachings. It is therefore to be understood that within the scope of the claims, the present invention may be practiced otherwise than as specifically described herein.
- 1: Power converter
- 11 A to 11F: Switching device
- 15: Snubber capacitor (surge absorbing member)
- 21: Heat sink
- 21b: Mount surface
- 23: Bus bar
- 23a: First bus bar (conduction member, first conduction member)
- 25: Bus bar
- 25a: First bus bar (conduction member, second conduction member)
- 27: Heat-conductive member
- 27a: First end surface
- 27b: Second end surface
- 37a to 37d: Terminal
- 39: Electro-insulating sheet (second electro-insulating member)
- 51: Electro-insulating member (first electro-insulating member)
- *L2*: Predetermined dimension

## Claims

1. A power converter (1), **characterized by**:
a heat sink (21) having a mount surface;
a plurality of switching devices (11A, 11B, 11C, 11D, 11E, 11F) disposed on the mount surface, each switching device (11A, 11B, 11C, 11D, 11E, 11F) of the plurality of switching devices (11A, 11B, 11C, 11D, 11E, 11F) having a terminal; and
an electro-conductive member (23a, 25a) having a planar shape, the electro-conductive member (23a, 25a) being connected to the terminal of the each switching device (11A, 11B, 11C, 11D, 11E, 11F) and facing the mount surface with the plurality of switching devices (11A, 11B, 11C, 11D, 11E, 11F) disposed between the electro-conductive member (23a, 25a) and the mount surface.

2. The power converter (1) according to claim 1, further comprising a heat-conductive member (27) disposed between the each switching device (11A, 11B, 11C, 11D, 11E, 11F) and another switching device (11A, 11B, 11C, 11D, 11E, 11F), among the plurality of switching devices (11A, 11B, 11C, 11D, 11E, 11F), that is adjacent to the each switching device (11A, 11B, 11C, 11D, 11E, 11F) so that heat from the electro-conductive member (23a, 25a) is conducted to the heat sink (21) through the heat-conductive member (27).

3. The power converter (1) according to claim 2, wherein the heat-conductive member (27) is disposed near the terminal of the each switching device (11A, 11B, 11C, 11D, 11E, 11F).

4. The power converter (1) according to claim 2 or 3, wherein the heat-conductive member (27) has
a first end surface (27a) facing the mount surface, and
a second end surface (27b) facing the electro-conductive member (23a, 25a) and being larger in area than the first end surface (27a).

5. The power converter (1) according to claim 4, further comprising a first electro-insulating member (51) having a heat conductivity and disposed between the electro-conductive member (23a, 25a) and the second end surface (27b) of the heat-conductive member (27) and/or between the first end surface (27a) of the heat-conductive member (27) and the mount surface,
wherein when the first electro-insulating member (51) is disposed between the electro-conductive member (23a, 25a) and the second end surface (27b), the first electro-insulating member (51) has larger size than the second end surface (27b) by a predetermined dimension in a plane direction of the second end surface (27b), and
wherein when the first electro-insulating member (51) is disposed between the first end surface (27a) and the mount surface, the first electro-insulating member (51) has larger size than the first end surface (27a) by a predetermined dimension in a plane direction of the first end surface (27a).

6. The power converter (1) according to any one of claims 1 to 5,
wherein the electro-conductive member (23a, 25a) comprises
a first electro-conductive member (23a) having a planar shape parallel to the mount surface and being usable for a positive electrode, and
a second electro-conductive member (25a) having a planar shape parallel to the mount surface and being usable for a negative electrode, and
wherein the first electro-conductive member (23a) and the second electro-conductive member (25a) are laminated on each other via a second electro-insulating member (39) in a direction perpendicular to the mount surface.

7. The power converter (1) according to any one of claims 1 to 6, further comprising a surge absorbing member (15) disposed at a position opposite to the plurality of switching devices (11A, 11B, 11C, 11D, 11E, 11F) across the electro-conductive member (23a, 25a) and connected to the terminal of the each switching device (11A, 11B, 11C, 11D, 11E, 11F).

8. The power converter (1) according to any one of claims 1 to 7, wherein the heat sink (21) comprises a liquid-cooled heat sink (21) in which a liquid refrigerant flows.
